# EUROPÄISCHE PATENTSCHRIFT

(11) **EP 2 067 050 B1**
(45) Veröffentlichungstag und Bekanntmachung des Hinweises auf die Patenterteilung: **22.12.2010**
(21) Anmeldenummer: 06791413.5
(22) Anmeldetag: 28.09.2006
(51) Int. Cl.: G01R 31/327

(54) **DURCHFÜHRUNG UND ÜBERWACHUNG EINES SICHERHEITSTESTS FÜR EIN GERÄT MIT INTEGRIERTER ÜBERLASTFUNKTION**
PERFORMANCE AND MONITORING OF A SAFETY TEST FOR A DEVICE HAVING AN INTEGRATED OVERLOAD FUNCTION
EXÉCUTION ET SURVEILLANCE D'UN TEST DE SÉCURITÉ POUR UN APPAREIL AVEC FONCTION DE SURCHARGE INTÉGRÉE

(43) Veröffentlichungstag der Anmeldung: 10.06.2009
(73) Patentinhaber: SIEMENS AKTIENGESELLSCHAFT, 80333 München (DE)
(72) Erfinder: FRÖHLICH, Paul, 92237 Sulzbach-Rosenberg (DE); MEIER, Matthias, 92284 Poppenricht (DE); NEUMANN, Bernhard, 90556 Cadolzburg (DE); PRÖLSS, Manfred, 92263 Ebermannsdorf (DE); SCHUMANN, Gordon, 91052 Erlangen (DE)
(86) Internationale Anmeldenummer: PCT/DE2006/001713
(87) Internationale Veröffentlichungsnummer: WO 2008/037232

(56) Entgegenhaltungen:
- EP-A- 1 515 411
- WO-A-03/079031
- US-B1- 6 266 219
- US-B1- 6 472 882

## Beschreibung

Die Erfindung betrifft eine Vorrichtung und ein Verfahren zur Durchführung und Überwachung eines Sicherheitstests für ein Gerät mit integrierter Überlastfunktion sowie ein Gerät mit integrierter Überlastfunktion mit einer besagten Vorrichtung.

Die EP 1 515 411 A1 offenbart ein Testverfahren für Schalteinrichtungen. Hierbei wird über ein Analogsignal ein reduzierter Wert des eigentlichen Versorgungssignals, welche über einen Schalter fließt, simuliert. Der Vorteil hierbei besteht darin, dass mittels des Analogsignals die üblicherweise notwendigen Vorkehrungen hinsichtlich der Analysen der hohen Werte des Versorgungssignals vermieden werden. Einem Knoten wird das Analogsignal zur Auswertung bereitstellt. Der Knoten empfängt zudem Signale, welche den aktuellen Status des Schalters wiederspiegeln. Der Knoten kann folglich Tests anhand der niedrigeren Analogsignale durchführen. Derartige Tests/Analysen sind beispielsweise Auswertungen hinsichtlich des Überspannungsschutzes, eines Fehlerstroms, einer Über/Unterschreitung einer Frequenz, etc.

Eine derartige Vorrichtung bzw. ein derartiges Verfahren kommt bei Anwendungen in explosionsgefährdeten Bereichen zum Einsatz. Um z.B. Motoren im explosionsgefährdeten Bereich schützen zu dürfen, benötigen Überlastrelais eine EG-Baumusterprüfbescheinigung, eine so genannte ATEX-Zulassung (ATmosphere EXplosible). Für diese Zulassung ist eine Betrachtung des Systems (Überlastrelais) bezüglich der "funktionalen Sicherheit" erforderlich. Dies erfolgt bei neuen Geräteentwicklungen nach der IEC 61508. Bei einem Überlastrelais ist hier die kritische Kette *Strommessung - Verarbeitung - Abschaltung des Verbrauchers* zu betrachten. Aus dieser Betrachtung ergibt sich die Anforderung, in gewissen Zeitabständen einen Test der kompletten Kette durchzuführen. Dieser Test wird dem Anlagenbetreiber bzw. Anwender vorgeschrieben.

Die Teile *Strommessung* und *Verarbeitung* können vom Gerät automatisch selbst getestet werden. Die *Abschaltung* des *Verbrauchers* muss der Anwender durchführen. In Kundendokumentationen wird deshalb gewöhnlich dem Anwender vorgeschrieben, im Abstand von z.B. 36 Monaten einen Test durchzuführen. Der Anwender muss diesen durchführen und dokumentieren. Der Test erfordert eine Unterbrechung des Normalbetriebes in der zu testenden Anlage.

Der Erfindung liegt die Aufgabe zugrunde, eine Vorrichtung bzw. ein Verfahren vorzuschlagen, mit der bzw. dem die Durchführung und Überwachung des Sicherheitstests *Abschaltung des* Verbrauchers automatisch erfolgt.

Diese Aufgabe wird gelöst durch eine Vorrichtung zur Durchführung und Überwachung eines Sicherheitstests für ein Gerät mit integrierter Überlastfunktion, wobei der Sicherheitstest aus einer Abschaltung eines zugehörigen Verbrauchers besteht und wobei ein erstes Mittel zur Registrierung eines betriebsmäßigen Abschaltens des Verbrauchers als Sicherheitstest vorgesehen ist.

Die Aufgabe wird ferner gelöst durch ein Gerät mit integrierter Überlastfunktion und ein Verfahren mit den in Anspruch 6 und 7 angegebenen Merkmalen.

Durch die Registrierung des betriebsmäßigen Abschaltens des Verbrauchers als Sicherheitstest wird somit der Sicherheitstest ohne Zutun des Anwenders durchgeführt. Die Rückmeldung erfolgt über die Strommessung, den vorderen Teil der kritischen Kette. Beispielsweise bei Motormanagementsystemen oder Motorschutz- und Steuergeräten, bei denen ein Hilfskontakt auch für das betriebsmäßige Schalten des Verbrauchers, d.h. des Motors, verwendet wird, wird durch die erfindungsgemäße Vorrichtung jedes betriebsmäßige Schalten als Sicherheitstest betrachtet. Da der Verbraucher ja betriebsmäßig sowieso abgeschaltet wird, erfolgt der notwendige Test damit automatisch. Als durchzuführender Sicherheitstest ist hier *Abschaltung durch Hilfskontakt incl. Abschaltung durch Motorschütz* zu betrachten. Die erfindungsgemäße Vorrichtung ist auch für z.B. Motorstarter, Sanftstarter und Frequenzumrichter anwendbar. Beispielsweise bei Sanftstartern erfolgt die Abschaltung des Verbrauchers allerdings nicht über Hilfskontakte oder Motorschütze, sondern über Thyristoren.

Durch die Registrierung des betriebsmäßigen Schaltens als Sicherheitstest ist auch der Dokumentations- bzw. Nachweispflicht des Anwenders Genüge getan, eine Überwachung kann anhand der registrierten Tests erfolgen. Somit kann die manuelle Durchführung des vorgeschriebenen Sicherheitstests durch den Anwender entfallen. Ein zusätzlicher Effekt ist dabei der folgende: Je häufiger der Test durchgeführt wird, d.h. also je häufiger der Verbraucher betrieblich geschaltet wird, desto niedriger ist die Ausfallwahrscheinlichkeit "PFD" (Probability of Failure on Demand) des Systems. Da das statistische Ausfallverhalten von der Testhäufigkeit abhängt, wird das Einsatzspektrum größer.

In einer vorteilhaften Form der Ausgestaltung ist ein zweites Mittel zur Erfassung der Zeit nach einem Sicherheitstest vorgesehen. Auf diese Weise kann ein Anwender auch bei seltener geschalteten Verbrauchern kontrollieren, wie viel Zeit noch maximal bis zum nächsten vorgeschriebenen Sicherheitstest verbleibt und somit ggf. den Verbraucher manuell schalten, bevor der maximal zulässige Testabstand erreicht oder überschritten wird.

In einer weiteren vorteilhaften Ausführungsform ist ein drittes Mittel zur Ausgabe eines Warnhinweises vorgesehen, wenn die Zeit nach einem Sicherheitstest einen ersten einstellbaren Wert übersteigt. Somit wird der Anwender automatisch rechtzeitig gewarnt, dass ein Abschalten durchgeführt werden muss, bevor der maximal zulässige Testabstand (zur letzten Abschaltung des Verbrauchers) erreicht oder überschritten wird. Der einstellbare Wert kann dabei bereits vom Werk und/oder vom Anwender selbst eingestellt werden.

In einer weiteren vorteilhaften Ausführungsform ist ein viertes Mittel zur automatischen Abschaltung des Verbrauchers vorgesehen, wenn die Zeit nach einem Sicherheitstest einen zweiten einstellbaren Wert übersteigt. Dieser zweite einstellbare Wert ist dabei vorteilhafterweise bereits vom Werk auf den maximal vorgeschriebenen Zeitraum, z.B. 36 Monate, eingestellt und vom Anwender nicht änderbar. Somit kann sichergestellt werden, dass nach Ablauf des maximal zulässigen Testabstands (zur letzten Abschaltung des Verbrauchers) der Sicherheitstest auch wirklich durchgeführt wird.

In einer weiteren vorteilhaften Ausführungsform ist die Vorrichtung in das Gerät integriert. Somit weist das Gerät mit integrierter Überlastfunktion bereits die Funktionalität der automatischen Durchführung und Überwachung gewissermaßen als Komplettlösung auf, so dass sich ein Anwender nicht mehr um richtige Anschlüsse etc. der erfindungsgemäßen Vorrichtung kümmern muss.

Zusammenfassend betrifft die Erfindung die Durchführung und Überwachung eines Sicherheitstests für ein Gerät mit integrierter Überlastfunktion. Zur automatischen Durchführung und Überwachung des Sicherheitstests *Abschaltung des Verbrau*chers, der für Geräte mit einer ATEX-Zulassung erforderlich ist, wird eine Vorrichtung vorgeschlagen zur Durchführung und Überwachung eines Sicherheitstests für ein Gerät mit integrierter Überlastfunktion, wobei der Sicherheitstest aus einer Abschaltung des Verbrauchers besteht und wobei ein erstes Mittel zur Registrierung eines betriebsmäßigen Abschaltens als Sicherheitstest vorgesehen ist. Da der Verbraucher ja betriebsmäßig sowieso geschaltet wird, erfolgt der notwendige Test damit automatisch. Durch die Registrierung des betriebsmäßigen Schaltens als Sicherheitstest ist auch der Dokumentations- bzw. Nachweispflicht des Anwenders Genüge getan. Somit kann die manuelle Durchführung des vorgeschriebenen Sicherheitstests durch den Anwender entfallen.

## Patentansprüche

1. Vorrichtung zur Durchführung und Überwachung eines Sicherheitstests für ein Gerät mit integrierter Überlastfunktion, wobei der Sicherheitstest aus einer Abschaltung eines zugehörigen Verbrauchers besteht,
**dadurch gekennzeichnet, dass**
ein erstes Mittel zur Registrierung eines betriebsmäßigen Abschaltens des Verbrauchers als Sicherheitstest vorgesehen ist, wobei ein zweites Mittel zur Erfassung der Zeit nach einem Sicherheitstest vorgesehen ist, wobei ein drittes Mittel zur Ausgabe eines Warnhinweises vorgesehen ist, wenn die Zeit nach einem Sicherheitstest einen ersten einstellbaren Wert übersteigt.

2. Vorrichtung nach Anspruch 1,
wobei ein viertes Mittel zur automatischen Abschaltung des Verbrauchers vorgesehen ist, wenn die Zeit nach einem Sicherheitstest einen zweiten einstellbaren Wert übersteigt.

3. Vorrichtung nach einem der vorhergehenden Ansprüche, wobei die Vorrichtung in das Gerät integriert ist.

4. Gerät mit integrierter Überlastfunktion und einer Vorrichtung nach einem der Ansprüche 1 bis 3.

5. Verfahren zur Durchführung und Überwachung eines Sicherheitstests für zumindest ein Gerät mit integrierter Überlastfunktion,
**dadurch gekennzeichnet, dass**
der Sicherheitstest aus einer Abschaltung eines zugehörigen Verbrauchers besteht und ein betriebsmäßiges Abschalten des Verbrauchers als Sicherheitstest registriert wird.

6. Verfahren nach Anspruch 5,
wobei die Zeit nach einem Sicherheitstest erfasst wird.

7. Verfahren nach Anspruch 6,
wobei ein Warnhinweis ausgegeben wird, wenn die Zeit nach einem Sicherheitstest einen ersten einstellbaren Wert übersteigt.

8. Verfahren nach Anspruch 5 oder 7,
wobei der Verbraucher automatisch abgeschaltet wird, wenn die Zeit nach einem Sicherheitstest einen zweiten einstellbaren Wert übersteigt.

## Claims

1. Apparatus for performance and monitoring of a safety test for a device having an integrated overload function, wherein the safety test consists of an associated load being disconnected,
**characterized in that**
a first means is provided for registering correct disconnection of the load as a safety test, wherein a second means is provided for recording the time since a safety test, wherein a third means is provided for outputting warning information if the time since a safety test exceeds a first adjustable value.

2. Apparatus according to Claim 1,
wherein a fourth means is provided for automatic disconnection of the load if the time since a safety test exceeds a second adjustable value.

3. Apparatus according to one of the preceding Claims, wherein the apparatus is integrated in the device.

4. Device having an integrated overload function and an apparatus according to one of Claims 1 to 3.

5. Method for performance and monitoring of a safety test for at least one device having an integrated overload function, **characterized in that**
the safety test consists of disconnection of an associated load, and correct disconnection of the load is registered as a safety test.

6. Method according to Claim 5,
wherein the time since a safety test is recorded.

7. Method according to Claim 6,
wherein warning information is output if the time since a safety test exceeds a first adjustable value.

8. Method according to Claim 5 or 7,
wherein the load is disconnected automatically if the time since a safety test exceeds a second adjustable value.

## Revendications

1. Dispositif pour effectuer et contrôler un test de sécurité pour un appareil ayant une fonction de surcharge intégrée, dans lequel le test de sécurité consiste en une mise hors circuit d'un consommateur associé,
**caractérisé en ce que**
il est prévu, comme test de sécurité, un premier moyen d'enregistrement d'une mise hors circuit du consommateur, conforme au fonctionnement, un deuxième moyen de relevé du temps qui s'est écoulé après un test de sécurité étant prévu, un troisième moyen d'émission d'une indication d'avertissement étant prévu, si le temps qui s'est écoulé après un test de sécurité dépasse une première valeur réglable.

2. Dispositif suivant la revendication 1,
dans lequel il est prévu un quatrième moyen de mise hors circuit automatique du consommateur, si le temps qui s'est écoulé après un test de sécurité dépasse une deuxième valeur réglable.

3. Dispositif suivant l'une des revendications précédentes, dans lequel le dispositif est intégré dans l'appareil.

4. Appareil ayant une fonction de surcharge intégrée et un dispositif suivant l'une des revendications 1 à 3.

5. Procédé pour effectuer et contrôler un test de sécurité pour au moins un appareil ayant une fonction de surcharge intégrée,
**caractérisé en ce que**
le test de sécurité est constitué d'une mise hors circuit d'un consommateur associé et on enregistre comme test de sécurité une mise hors circuit du consommateur conforme au fonctionnement.

6. Procédé suivant la revendication 5,
dans lequel on relève le temps qui s'écoule après un test de sécurité.

7. Procédé suivant la revendication 6,
dans lequel on émet une indication d'avertissement, si le temps qui s'est écoulé après un test de sécurité dépasse une première valeur réglable.

8. Procédé suivant la revendication 5 ou 7,
dans lequel on met automatiquement hors circuit le consommateur, si le temps qui s'est écoulé après un test de sécurité dépasse une deuxième valeur réglable.
